**Europäisches Patentamt**

**European Patent Office**

**Office européen des brevets**

(11) Veröffentlichungsnummer : **0 019 884 B1**

# (12) EUROPÄISCHE PATENTSCHRIFT

(45) Veröffentlichungstag der Patentschrift :
26.01.83

(21) Anmeldenummer : 80102898.6

(22) Anmeldetag : 23.05.80

(51) Int. Cl.³ : **H 02 H  3/04**, H 02 H  9/04, G 01 R 27/14, H 01 C  8/04

(54) **Schaltungsanordnung zur Überwachung der Betriebseigenschaften eines funkenstreckenlosen Überspannungsableiters.**

(30) Priorität : 23.05.79 JP 62696/79

(43) Veröffentlichungstag der Anmeldung :
10.12.80 Patentblatt 80/25

(45) Bekanntmachung des Hinweises auf die Patenterteilung : 26.01.83 Patentblatt 83/04

(84) Benannte Vertragsstaaten :
CH DE LI SE

(56) Entgegenhaltungen :
CH A 503 401

Patents Abstracts of Japan Band 2, Nr. 129, 27. Oktober 1978, Seite 7 736E78 & JP-A-53-95248.
Patents Abstracts of Japan Band 3, Nr. 89, 28. Juli 1979 Seite 38E126 & JP-A-54-66442.

(73) Patentinhaber : **FUJI ELECTRIC CO. LTD.**
**1-1, Tanabeshinden, Kawasaki-ku**
**Kawasaki 210 (JP)**

(72) Erfinder : **Kiyokuni, Nobuaki, Dipl.-Ing.**
**3-29-20 Youkoodai Isogoku**
**Yokohama (JP)**

(74) Vertreter : **Mehl, Ernst, Dipl.-Ing. et al**
**Postfach 22 01 76**
**D-8000 München 22 (DE)**

# Schaltungsanordnung zur Überwachung der Betriebseigenschaften eines funkenstreckenlosen Überspannungsableiters

Die Erfindung bezieht sich auf eine Schaltungsanordnung zur Überwachung der Betriebseigenschaften eines funkenstreckenlosen Überspannungsableiters, der als Blitzschutz in elektrischen Versorgungssystemen eingesetzt werden soll.

Seit einiger Zeit werden zahlreiche funkenstreckenlose Überspannungsableiter benutzt, die keine in Reihe geschalteten Funkenstrecken aufweisen, sondern aus einem nichtlinearen Widerstandsmaterial gebildet sind, das hauptsächlich aus Zinkoxid besteht. Diese Bauart von funkenstreckenlosen Überspannungsableitern hat bis jetzt noch nicht voll gesicherte Nachweise ihrer Zuverlässigkeit aufgrund von Langzeiterfahrungen bei ihrem Gebrauch im tatsächlichen Netzeinsatz erbracht. Daher bedarf es periodischer Prüfungen der Leistungsfähigkeit von in Betrieb befindlichen funkenstreckenlosen Überspannungsableitern.

Im allgemeinen lautet die Beziehung zwischen einer Gleichspannungskomponente (eine an einem Widerstand hervorgerufene Spannungskomponente) an einem Überspannungsableiter und einem über diesen fließenden Strom im Falle eines funkenstreckenlosen Überspannungsableiters, der im wesentlichen aus Zinkoxid besteht, $i = k \cdot v^\alpha$ (1), worin i den Strom, v die Spannungskomponente, k eine Konstante und $\alpha$ einen Nichtlinearitätsfaktor bedeutet. Der funkenstreckenlose Überspannungsableiter auf der Basis von Zinkoxid hat einen größeren Wert von $\alpha$ in der Gleichung (1) im Vergleich mit herkömmlichen Überspannungsableitern mit einer Funkenstrecke und Widerstandselementen auf der Basis von Siliziumkarbid (SiC). Die Ersatzschaltung tatsächlich ausgeführter funkenstreckenloser Überspannungsableiter enthält jedoch einen Widerstand und eine parallel dazu geschaltete Kapazität, da er eine ziemlich große statische Kapazität aufgrund des Körpers aus Widerstandsmaterial besitzt. Daher ist der in der Gleichung (1) angegebene Strom von einer Stromkomponente begleitet, die auf dieser Kapazität beruht.

Man nimmt im allgemeinen an, daß eine Verschlechterung der Eigenschaften des Zinkoxidelementes in der Kennlinie eines funkenstreckenlosen Überspannungsableiters im wesentlichen durch eine Gleichstromkomponente dargestellt werden kann, d.h. durch eine in dem Widerstand erzeugte Stromkomponente. Daher umfassen bekannte Verfahren zur Prüfung der Kennlinie funkenstreckenloser Ableiter die Erfassung der kapazitiven Stromkomponente und den Abzug hiervon des gesamten, durch den funkenstreckenlosen Überspannungsableiter fließenden Stromes. Zum Beispiel wird in Reihe mit dem Überspannungsableiter ein Prüfglied geschaltet, das in seiner Dimensionierung dem inneren Ableiterelement des funkenstreckenlosen Ableiters entspricht, so daß an dem Prüfglied eine in Phase mit der Klemmenspannung des Ableiters liegende Spannung erzeugt wird. Ferner wird ein Signal von dem gesamten Ableiterstrom abgezogen, das durch Differenzierung der Klemmenspannung des Prüfgliedes erzeugt und bis zur Höhe der kapazitiven Stromkomponente vervielfacht ist. Die Einstellung der Vervielfachung zu dem Zweck, das differenzierte Signal des Prüfgliedes der kapazitiven Stromkomponente des Ableiters gleichzumachen, wird dadurch erreicht, daß man Mittelwerte des Stromes des Prüfgliedes und des Ableiters miteinander unter der Bedingung vergleicht, daß die Spannung an dem Prüfglied so erniedrigt ist, daß die Stromkomponente an dem Widerstand des Prüfgliedes vernachlässigbar sein kann. Die Stromkomponente an dem Widerstand des funkenstreckenlosen Überspannungsableiters wird aus der Differenz zwischen diesem Signal und dem Gesamtstrom des funkenstreckenlosen Überspannungsableiters gewonnen.

Somit besteht das bekannte Prüfverfahren für die Kennlinie funkenstreckenloser Ableiter in der Erfassung der Widerstandsstromkomponente und dem Auffinden ihrer Änderung mit der Zeit, um zu beurteilen, ob der Überspannungsableiter richtig arbeitet. Bei in einem Versorgungsnetz eingebauten funkenstreckenlosen Überspannungsableitern schließt jedoch der durch den Überspannungsableiter fließende Strom weitgehend die in der Kapazität erzeugte Stromkomponente ein, während die in dem Widerstand erzeugte Stromkomponente sehr klein ist, so daß ihr gesondertes Auffinden bedeutende Schwierigkeiten macht. Diese Schwierigkeit kann noch dadurch vergrößert werden, daß die Versorgungsspannung harmonische Anteile besitzt, da sich die Stromkomponente an dem Widerstand von den harmonischen Bestandteilen kaum trennen läßt. Bekannte Verfahren zum Messen der Kennlinie funkenstreckenloser Überspannungsableiter sind daher nicht ausreichend, um zu genauen Ergebnissen zu gelangen.

Der Erfindung liegt somit die Aufgabe zugrunde, durch einen einfachen Vorgang zu einer genauen Anzeige des Zustandes der betrieblichen Kennwerte bzw. des Betriebsverhaltens eines funkenstreckenlosen Überspannungsableiters zu gelangen.

Zur Lösung dieser Aufgabe sieht die Erfindung einen erdseitig mit dem funkenstreckenlosen Überspannungsableiter in Reihe geschalteten Kondensator und eine parallel zu dem Kondensator geschaltete Gleichspannungsquelle sowie einen Strommesser vor, der zwischen den Kondensator und die Gleichspannungsquelle geschaltet ist.

Bei der Schaltungsanordnung nach der Erfindung kann man die durch den Überspannungsableiter fließende Gleichstromkomponente ohne Störung durch eine auftretende Überspannung bequem messen.

Vorzugsweise kann bei dieser Schaltungsanordnung die Höhe der Gleichspannung der Gleichspannungsquelle veränderbar sein, so daß der Nichtlinearitätsfaktor $\alpha$ aus der Beziehung zwischen der veränderbaren Gleichspannung und der Gleichstromkomponente gemessen werden kann.

Die Erfindung wird im folgenden anhand des in den Zeichnungen dargestellten Ausführungsbeispieles näher erläutert.

Die Figur 1 ist ein Übersichtsschaltplan, der eine Schaltungsanordnung nach der Erfindung zur Überwachung der Betriebseigenschaften eines funkenstreckenlosen Überspannungsableiters zeigt.

Die Figur 2 ist eine Darstellung von Kurvenformen von Spannungs- und Stromkomponenten in einer Schaltungsanordnung nach der Erfindung. Dabei zeigt die Fig. 2(A) die Klemmenspannung v des funkenstreckenlosen Überspannungsableiters, Fig. 2(B) eine kapazitive Stromkomponente $i_C$ an der Ersatzkapazität C des Überspannungsableiters, Fig. 2(C) eine Stromkomponente $i_R$ an dem Ersatzwiderstand R des Überspannungsableiters und Fig. 2(D) den Gesamtstrom i des Überspannungsableiters.

In der Figur 3 sind Kurvenformen für den Fall dargestellt, daß die Gleichspannungsquelle der Schaltungsanordnung gemäß der Fig. 1 den Wert Null hat. Die in den Fig. 3(A) bis 3(D) dargestellten Größen entsprechen denen in den Fig. 2(A) bis 2(D).

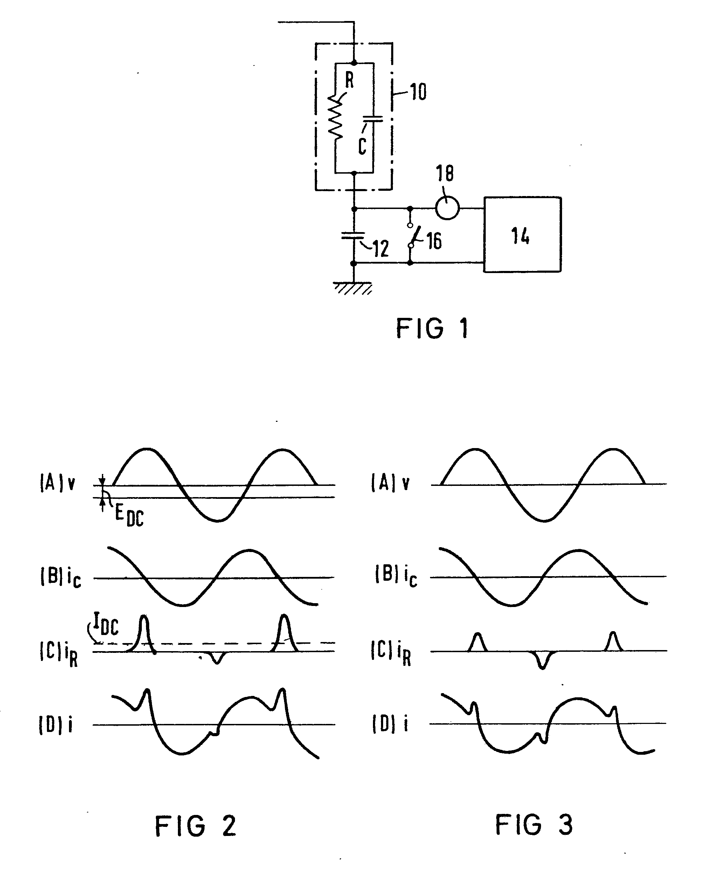

Die Fig. 1 ist ein Übersichtsschaltplan, welcher die Erfindung in Verbindung mit einem funkenstreckenlosen Überspannungsableiter 10 zeigt, der als Ersatzschaltbild dargestellt ist mit einem Widerstand R und einer Ersatzkapazität C, die parallel geschaltet sind. Ein Kondensator 12 ist zwischen den funkenstreckenlosen Überspannungsableiter und Erde geschaltet. Eine Gleichspannungsquelle 14 für Hochspannung und ein Kurzschlußschalter 16 sind parallel zu dem Kondensator 12 geschaltet, und ein Strommesser 18 ist in die Verbindung zwischen dem Kondensator 12 und der Gleichspannungsquelle 14 geschaltet. Der Kondensator 12 hat eine ausreichend große Kapazität zwecks niedriger Impedanz bei der Frequenz des über den funkenstreckenlosen Überspannungsableiter 10 fließenden Stromes.

Im Betrieb der Schaltungsanordnung wird eine bestimmte Gleichspannung $E_{DC}$ zwischen dem funkenstreckenlosen Überspannungsableiter 10 und Erde aufgebracht. Dann erscheinen eine Klemmenspannung v des Überspannungsableiters 10 und ein durch diesen fließender Strom i mit ihren entsprechenden Komponenten $i_C$ und $i_R$, die in der Kapazität C und dem Widerstand R des Überspannungsableiters erzeugt werden, mit Kurvenformen, wie sie in den Fig. 2(A) bis 2(D) dargestellt sind. In diesen ist der Wert der Komponente $i_R$ des Widerstandsstromes, der in den Halbwellenabschnitten erscheint, in denen die Gleichspannung $E_{DC}$ und die Klemmenspannung des Überspannungsableiters einander positiv überlagert sind, viel größer als der Wert von $i_R$, der in den anderen Halbwellenabschnitten (vgl. Fig. 2(C)) erscheint. Ferner wird eine Gleichstromkomponente $I_{DC}$, die dort erscheint, von der Gleichspannungsquelle 14 bereitgestellt. Durch Messung der Größe der Gleichstromkomponente $I_{DC}$ mit dem Strommesser 18 kann daher eine Zunahme der Widerstandsstromkomponente im Vergleich mit ihrem Ausgangswert zu der Zeit Aufstellung des Überspannungsableiters festgestellt werden.

Der Wert dieser Zunahme dient als Maß dafür, ob die Betriebseigenschaften des Überspannungsableiters einwandfrei sind. Bei der Erfindung werden die kapazitive Komponente $i_C$ und ein Wechselstromteil der Komponente $i_R$ über den Überspannungsableiter 10 nach Erde durch den Kondensator 12 entladen, so daß die Schaltungsanordnung zur Überwachung der Ableiterkennlinie in vorteilhafter Weise gegen Überspannungen geschützt werden kann, die an dem Ableiter auftreten, da sie durch den Kondensator 12 aufgenommen werden.

Falls die Schaltungsanordnung keine Gleichspannungsquelle 14 oder eine Ausgangsspannung der Gleichspannungsquelle 14 vom Wert Null hat, verhält sie sich ähnlich wie die erwähnten bekannten Verfahren und führt zu einem Meßergebnis der Betriebseigenschaften, wie es in den Fig. 3(A) bis 3(D) anstelle von 2(A) bis 2(D) gezeigt ist. Die Komponente $i_R$ ist in diesem Fall wesentlich kleiner als die kapazitive Komponente $i_C$ (obwohl die Darstellung der Kurvenform in Fig. 3(C) in der Amplitude übertrieben ist), und daher ist eine angemessene und genaue Messung nicht erreichbar, solange nicht zusätzliche Mittel für die Verstärkung oder ähnliches vorgesehen sind.

Ferner kann die Schaltungsanordnung nach der Erfindung mit Mitteln zur Veränderung der Gleichspannung $E_{DC}$ der Gleichspannungsquelle 14 versehen sein, so daß die Beziehung zwischen der Größe der Gleichstromkomponente $I_{DC}$ und der veränderbaren Gleichspannung $E_{DC}$ aus den Anzeigen des Strommessers 18 erhalten werden kann. Dann läßt sich die Veränderung des Nichtlinearitätsfaktors $\alpha$ im Vergleich mit seinem Ausgangswert zur Zeit der Aufstellung des Überspannungsableiters erhalten. Somit kann die Schaltungsanordnung nach der Erfindung weitergehende Messungen als die bekannten Verfahren liefern.

Dem Vorstehenden ist zu entnehmen, daß die Erfindung unter Verwendung einer einfach aufgebauten Schaltungsanordnung auf einfache und genaue Weise die betrieblichen Kennwerte eines funkenstreckenlosen Überspannungsableiters im angeschlossenen Zustand zu erfassen gestattet. Ferner kann die Messung des Nichtlinearitätsfaktors $\alpha$, die mit den bekannten Verfahren kaum durchführbar ist, auf einfache Weise mittels der Schaltungsanordnung nach der Erfindung durchgeführt werden, wodurch die Überwachung funkenstreckenloser Überspannungsableiter be-

deutend verbessert wird.

**Ansprüche**

1. Schaltungsanordnung zur Überwachung der Betriebseigenschaften eines funkenstreckenlosen Überspannungsableiters (10), gekennzeichnet durch einen erdseitig mit dem Überspannungsableiter (10) in Reihe geschalteten Kondensator (12) und eine parallel zu dem Kondensator (12) geschaltete Gleichspannungsquelle (14) sowie durch einen Strommesser (18), der zwischen den Kondensator (12) und die Gleichspannungsquelle (14) geschaltet ist.

2. Schaltungsanordnung nach Anspruch 1, dadurch gekennzeichnet, daß die Höhe der Gleichspannung der Gleichspannungsquelle (14) veränderbar ist.

**Claims**

1. A circuit arrangement for monitoring the operating characteristics of a surge arrester (10) that does not incorporate any spark gaps, characterised by a capacitor (12) connected in series with the surge arrester (10) to lie between the arrester and an earth terminal, and a direct voltage source (14) connected across the capacitor (12) by a current meter (18) which is switched between the capacitor (12) and the direct voltage source (14).

2. A circuit arrangement as claimed in Claim 1, characterised in that the voltage level of the direct voltage source (14) is changeable.

**Revendications**

1. Circuit de surveillance des propriétés de fonctionnement d'un dispositif (10), sans éclateur, dérivant les surtensions, caractérisé par un condensateur (12) monté, du côté de la terre, en série avec le dispositif (10) dérivant les surtensions et par une source de tension continue (14) montée en parallèle avec le condensateur (12), ainsi que par un ampèremètre (18) qui est monté entre le condensateur (12) et la source de tension continue (14).

2. Circuit suivant la revendication 1, caractérisé en ce que le niveau de tension continue de la source de tension continue (14) est susceptible d'être modifié.

FIG 1

FIG 2

FIG 3